# DEMANDE DE BREVET EUROPEEN

(11) **EP 1 884 783 A1**
(43) Date de publication de la demande: **06.02.2008**
(21) Numéro de dépôt: 07113359.9
(22) Date de dépôt: 27.07.2007
(51) Int. Cl.: G01R 15/18

(54) **Capteur de courant à excitation magnétique alternative**

(30) Priorité: 31.07.2006 FR 0653209
(71) Demandeur: COMMISSARIAT A L'ENERGIE ATOMIQUE, 75015 Paris (FR)
(72) Inventeur: Delevoye, Elisabeth, 38000, GRENOBLE (FR); Beranger, Marc, 38410, ST MARTIN D'URIAGE (FR)
(74) Mandataire: Poulin, Gérard

(57) **Abrégé**

L'invention concerne un dispositif de mesure de courant comprenant un capteur de courant comportant :
- un circuit magnétique (102,104),
- une pluralité de bobinages dont au moins un bobinage d'excitation (110) chargé de l'excitation du circuit magnétique,
- au moins un bobinage de détection (120),

le capteur étant doté de bobinages formant un transformateur dont au moins un bobinage primaire (140) en regard du circuit magnétique par lequel un courant I à mesurer est destiné à entrer, et au moins un bobinage secondaire (160) en regard du circuit magnétique susceptible de produire un champ magnétique de contre réaction.

## Description

### DOMAINE TECHNIQUE

La présente invention concerne le domaine de la mesure de courant, et concerne un dispositif de mesure de courant doté d'un capteur de courant amélioré à excitation magnétique variable, pour la mesure d'un courant continu ou alternatif. Le dispositif de mesure de courant suivant l'invention comprend, sur un même support, des bobinages d'excitation et de détection, ainsi qu'au moins un bobinage que le courant à mesurer est destiné à traverser. L'invention s'applique au domaine de la microélectronique et des micro-technologies et prévoit la réalisation d'un microcapteur de courant, robuste vis-à-vis des surintensités, et ayant des performances améliorées notamment en termes de bande passante, de puissance dissipée, d'immunité vis-à-vis des perturbations électromagnétiques liées à l'environnement.

### ART ANTÉRIEUR

Il existe de nombreuses techniques différentes pour mesurer un courant électrique. On peut faire notamment appel à des technologies à isolement galvanique, pour lesquelles la mesure du courant est indirecte et réalisée par détection d'un champ magnétique créé par ce courant. La mesure d'un courant élevé peut être réalisée notamment par l'intermédiaire d'un shunt ou d'un transformateur de courant, dont le rôle est d'adapter le courant élevé à mesurer à un composant. Une autre méthode classiquement employée est la pince ampèremétrique à cellule magnétique, par exemple de type à effet « Hall », ou de type « fluxgate », ou de type « Rogowski ». Le type de capteur utilisé pour une mesure de courant électrique sera choisi en fonction des besoins spécifiques de l'application, telles que:
- la gamme de mesure, la valeur crête ou efficace du courant maximal à mesurer,
- la précision et/ou la résolution souhaitée,
- la bande passante, la fréquence maximale, la mesure ou non du courant continu.

Un shunt est assimilable à une résistance de précision de faible valeur. Le courant à mesurer traverse cette résistance et provoque une chute de tension à ses bornes, qui est transmise à un dispositif conditionneur de signaux tel que par exemple un convertisseur analogique/numérique. La résistance de précision comporte généralement 4 bornes pour éviter les effets indésirables parasites des connexions. Un shunt peut comporter deux bornes pour le raccordement du circuit courant, et deux bornes de dérivation pour la mesure de la chute de tension. Le shunt permet d'effectuer des mesures de courant continu, mais présente notamment une bande passante limitée à plusieurs kHz typiquement, et introduit du bruit.

Un transformateur de courant comporte généralement un enroulement dit « primaire » et un enroulement dit « secondaire » autour d'un circuit magnétique. Un courant à mesurer parcours le primaire doté d'un nombre N₁ donné de spires de section élevée, généralement une seule spire, tandis que le secondaire comporte un nombre N₂ de spires de faible section. Un tel type de capteur supporte bien des surcharges ou des court-circuits et présente une bande passante qui peut s'étendre par exemple de 50 Hz à 50 kHz. Les capteurs à transformateur ont cependant pour inconvénient de ne pas permettre une mesure de courant continu.

Un dispositif de pince de courant est généralement formé d'un circuit magnétique éventuellement ouvert, d'un capteur magnétique, par exemple de type à effet Hall et d'un bobinage de contre-réaction. La pince entoure un conducteur ou un ensemble de conducteurs par lequel, un courant que l'on souhaite mesurer, passe. Avec un tel dispositif, la mesure est réalisée entièrement sans contact et sans raccordement physique sur le conducteur par lequel circule le courant à mesurer.

En ce qui concerne les dispositifs à pinces de courant, il existe des pinces de courant particulières à capteur de type « Rogowski » qui ne sont pas dotées de circuit magnétique. Le document : *"*PCB Rogowski coil designs and performances for novel protective relaying" Kojovic, Power Engineering Society General Meeting, IEEE Volume 2, 13-17 July 2003*,* présente un tel type de capteur. Une ou plusieurs bobines sont couplées avec le conducteur par lequel passe le courant à mesurer, et permettent de créer une tension induite. Avec un tel type de capteur, le gain et le décalage de mesure (« offset » selon la terminologie anglo-saxonne) dépendent de nombreux paramètres physiques et géométriques tel que la dimension de l'entrefer, la position relative du capteur dans l'entrefer, le centrage du conducteur dans la pince, la perméabilité du circuit magnétique, la proximité d'éventuels objets magnétiques, l'amplitude et la direction de champs magnétiques perturbateurs extérieurs.

Le fluxgate est un capteur de champ magnétique très sensible, dont la bande passante s'étend du continu à plusieurs dizaines de kHz. Le capteur fluxgate comporte, autour d'un circuit magnétique à très forte perméabilité magnétique, une bobine d'excitation et une bobine de détection. La bobine d'excitation sature le circuit magnétique sous un champ alternativement positif et négatif. La bobine de détection est sensible à un déséquilibre entre le champ positif et négatif. Ce déséquilibre est provoqué par une source extérieure, par exemple le champ magnétique terrestre dans le cas d'un capteur de champ. Dans le cas d'une pince de courant à capteur fluxgate, le déséquilibre est provoqué par le courant à mesurer circulant dans un conducteur central. Le conducteur dans lequel circule le courant à mesurer et le capteur constituent deux éléments indépendants ou qui ne sont pas en contact. Dans un tel dispositif, les performances de mesure dépendent du contrôle de la position relative du capteur par rapport au conducteur. Par ailleurs, la distance entre le conducteur du courant à mesurer est de l'ordre du millimètre et peut difficilement être réduite à une valeur très faible.

Il se pose le problème de trouver un nouveau dispositif de capteur de courant, ne présentant pas les inconvénients évoqués ci-dessus.

### EXPOSÉ DE L'INVENTION

L'invention concerne un dispositif de mesure de courant doté d'au moins un capteur de courant comportant .
- un circuit magnétique,
- une pluralité de bobinages en regard du circuit magnétique dont au moins un bobinage d'excitation chargé de l'excitation du circuit magnétique,
- au moins un bobinage dit de « courant », qu'un courant I à mesurer est destiné à traverser et destiné à produire un champ magnétique donné,
- au moins un bobinage de détection.

Le capteur peut éventuellement fonctionner en boucle ouverte dans un cas où l'information mesurée concerne une détection d'un passage à zéro du courant.

Selon une mise en oeuvre, le capteur peut comprendre au moins un bobinage dit de « contre réaction », destiné à produire un champ magnétique de contre réaction s'opposant au champ magnétique donné. Le dispositif de mesure de courant est dans ce cas susceptible de fonctionner en boucle fermée.

Selon une première possibilité de mise en oeuvre, le bobinage de détection peut être le bobinage de contre réaction.

Selon une deuxième possibilité de mise en oeuvre, le bobinage de détection et le bobinage de contre réaction peuvent être des bobinages distincts.

Le capteur de courant peut comprendre au moins un premier bobinage comportant une première pluralité de zones conductrices situées en regard du circuit magnétique et connectées entre elles en parallèle, et au moins un deuxième bobinage, susceptible d'être couplé par couplage magnétique au premier bobinage, et comportant une deuxième pluralité de zones conductrices situées en regard du circuit magnétique et connectées entre elles en série.

Selon une mise en oeuvre possible, au moins plusieurs zones conductrices de la première pluralité de zones conductrices peuvent être situées en regard respectivement d'une ou être superposées respectivement à une, zone conductrice de même surface appartenant à la deuxième pluralité de zones conductrices.

Le dispositif de mesure de courant selon l'invention est susceptible d'adopter une première configuration dite « de mesure de courants élevés » dans laquelle ledit premier bobinage est le bobinage « de courant » et dans laquelle ledit deuxième bobinage est le bobinage « de contre réaction ».

Le dispositif de mesure de courant selon l'invention est susceptible d'adopter une deuxième configuration dite « de mesure de courants faibles » dans laquelle ledit premier bobinage est le bobinage « de contre réaction » et dans laquelle ledit deuxième bobinage est le « bobinage de courant ». Dans ces deux configurations, le courant de contre-réaction est égal au courant à mesurer multiplié par un rapport de transformation.

Le dispositif de mesure de courant peut comprendre en outre : des moyens de commutation aptes à placer le dispositif de mesure de courant dans la première configuration ou dans la deuxième configuration et faire passer le dispositif de mesure de courant de la première configuration à la deuxième configuration ou de la deuxième configuration à la première configuration.

Selon une possibilité de mise en oeuvre, le circuit magnétique du capteur peut être formé d'au moins un premier noyau magnétique et d'au moins un deuxième noyau magnétique parallèle au premier noyau.

L'agencement du bobinage d'excitation peut être prévu de manière à produire, une première composante de champ d'excitation de sens donné au niveau du premier noyau, et une deuxième composante de champ d'excitation de même sens au niveau du deuxième noyau.

Le bobinage d'excitation peut comprendre une pluralité de zones conductrices situées en regard du circuit magnétique et reliées entre elles en série.

L'agencement du bobinage de détection peut être prévu pour effectuer une mesure différentielle entre un champ magnétique au niveau du premier noyau et un champ magnétique au niveau du deuxième noyau.

Le bobinage de détection peut être formé d'une pluralité de bagues conductrices connectées entre elles, le circuit magnétique étant situé à l'intérieur d'au moins plusieurs desdites bagues.

Le dispositif de mesure de courant selon l'invention peut comprendre en outre : un circuit électronique de contre réaction connecté au bobinage de détection et apte à délivrer un courant de contre réaction au bobinage de contre réaction.

Le dispositif de mesure de courant selon l'invention peut comprendre en outre : un circuit d'excitation apte à délivrer un signal d'excitation en entrée du bobinage d'excitation.

Selon une mise en oeuvre avantageuse, le circuit d'excitation peut comprendre des moyens générateurs d'impulsions aptes à émettre le signal d'excitation en entrée du bobinage d'excitation sous forme d'une succession d'impulsions.

Le dispositif de mesure de courant peut comprendre en outre un conducteur par lequel le courant I à mesurer provient ou est destiné à provenir, connecté en série au capteur.

L'invention concerne un dispositif microélectronique comprenant un dispositif tel que défini précédemment.

L'invention cumule les avantages des capteurs de type shunt et de type transformateur de courant. Le capteur de l'invention permet une mesure des courants continus contrairement aux transformateurs. Le dispositif suivant l'invention présente une bande passante importante qui peut être du continu à plusieurs centaines de kHz, une très faible puissance dissipée, une grande robustesse vis-à-vis des surintensités.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un principe de fonctionnement d'un dispositif de mesure de courant électrique mis en oeuvre suivant l'invention,
- les figures 2A-2E, représentent, selon une vue de dessus, les bobinages d'un exemple de microcapteur de mesure de courant suivant l'invention se trouvant dans une configuration de mesure de courants élevés,
- les figures 3A-3D représentent, selon une vue en coupe, les bobinages d'un exemple de microcapteur de mesure de courant suivant l'invention se trouvant dans une configuration de mesure de courants élevés,
- la figure 4 représente, selon une vue de dessus, les bobinages d'un exemple de microcapteur de mesure de courant suivant l'invention se trouvant dans une configuration de mesure de courants faibles,
- la figure 5 représente, une variante de microcapteur de mesure de courant suivant l'invention, pour laquelle un bobinage joue à la fois le rôle de détection et de contre réaction,
- les figures 6A-6B illustrent des exemples d'assemblages d'un capteur de courant suivant l'invention avec un conducteur qu'un courant I à mesurer est destiné à traverser,
- la figure 7 représente, une variante de microcapteur de mesure de courant suivant l'invention, pour laquelle un bobinage joue à la fois le rôle de détection et de contre réaction, et est connecté à un circuit de détection et à un circuit de contre réaction,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

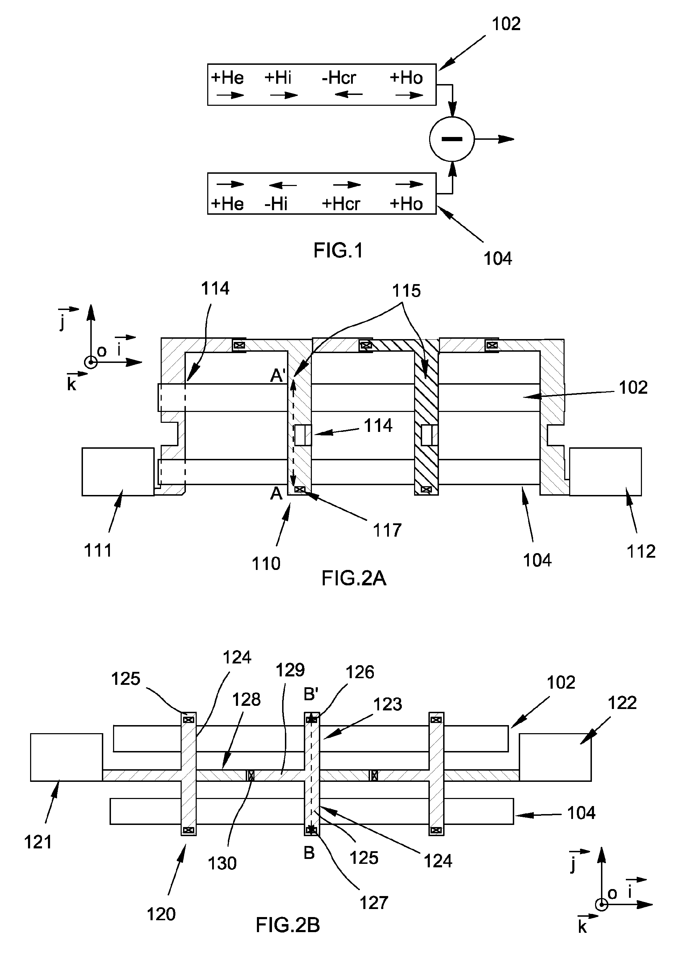

Un principe de fonctionnement d'un dispositif de mesure de courant suivant l'invention, va à présent être donné en liaison avec la figure 1. Le dispositif comprend un capteur de courant doté d'un circuit magnétique et de plusieurs bobinages réalisés sur un même support, par exemple sur un substrat microélectronique. Dans la présente description, le terme bobine ou bobinage n'est pas limité à un ensemble de spires formant un solénoïde. On appellera bobine ou bobinage tout au long de la présente description, un ensemble d'éléments conducteurs connectés entre eux et aptes à produire un champ magnétique.

Le circuit magnétique peut être formé d'un ou plusieurs noyaux magnétiques, par exemple d'un premier noyau magnétique 102 et d'un deuxième noyau magnétique 104, par exemple sous forme de deux branches parallèles. Le dispositif de mesure de courant comprend en outre, comme dans un dispositif de type fluxgate, des moyens d'excitation (non représentés) comportant au moins un bobinage d'excitation chargé de l'excitation du circuit magnétique et intégré au capteur. Les moyens d'excitation sont prévus pour saturer le circuit magnétique sous un champ d'excitation alternatif, par exemple alternativement positif et négatif. Le bobinage d'excitation peut être relié à un circuit d'excitation apte à délivrer un courant d'excitation sous forme par exemple d'un courant alternatif, ou avantageusement, d'une succession d'impulsions de courant de signes alternativement opposés. L'agencement du bobinage d'excitation vis-à-vis du circuit magnétique est tel qu'une composante du champ d'excitation +He est susceptible d'être générée au niveau du premier noyau 102, et qu'une composante du champ d'excitation +He sensiblement de même intensité et de même sens est susceptible d'être générée au niveau du deuxième noyau 104.

Le dispositif de mesure de courant comprend également des moyens de détection (non représentés) dotés d'au moins un bobinage récepteur ou de détection intégré au capteur de courant. Le bobinage de détection est formé d'une pluralité d'éléments conducteurs connectés en série, répartis le long des noyaux 102, 104. Le bobinage de détection est agencé, de manière à ce qu'une mesure différentielle entre les composantes de champs magnétiques au niveau du noyau 102, et les composantes de champs magnétiques au niveau du noyau 104, puisse être effectuée. Le champ d'excitation He et le champ extérieur Ho par exemple égal au champ terrestre plus une composante liée à l'environnement du capteur, s'annulent et ne déséquilibrent pas les branches du circuit magnétique. Le capteur est ainsi insensible au champ magnétique terrestre et aux perturbations environnementales.

Le capteur de courant est également doté d'au moins un bobinage dit « de courant » (non représenté) par lequel un courant I que l'on souhaite mesurer, est destiné à passer. Le passage du courant I dans le bobinage « de courant » permet de produire un champ magnétique dit « champ magnétique primaire ». Le bobinage de courant est agencé de sorte qu'une composante +Hi du champ primaire est susceptible d'être générée au niveau du premier noyau 102, et qu'une composante -Hi du champ primaire sensiblement de même intensité et de sens opposé est susceptible d'être générée au niveau du deuxième noyau 104.

Le capteur peut être prévu pour fonctionner en boucle fermée. Le signal de sortie peut être réinjecté dans des moyens formant une contre réaction, prévus pour produire un champ magnétique de contre réaction Hcr s'opposant au champ magnétique primaire, de manière à travailler à champ nul.

Les moyens formant une contre réaction peuvent comprendre au moins un bobinage de contre réaction intégré au capteur. Le champ magnétique de contre réaction est provoqué par le passage d'un courant de contre réaction dans le bobinage de contre réaction, le courant de contre réaction étant égal au courant à mesurer multiplié par un rapport de transformation. Les bobinages « de courant » et de contre réaction » sont susceptibles de former un transformateur. Parmi les bobinages formant le capteur, au moins un premier bobinage est formé d'une pluralité d'éléments conducteurs en série situés en regard du circuit magnétique, et est couplé magnétiquement à au moins un deuxième bobinage formé d'une pluralité d'éléments conducteurs en parallèle situés en regard du circuit magnétique.

Selon une première possibilité de configuration du dispositif de mesure de courant, adaptée à une mesure de courants élevés par exemple comprise entre 10 mA et 10 A, le premier bobinage du capteur formé d'une pluralité d'éléments conducteurs connectés en parallèle, peut jouer le rôle du bobinage « de courant », le deuxième bobinage formé d'une pluralité d'éléments conducteurs en série, jouant le rôle du bobinage « de contre réaction ». Dans ce cas, le bobinage formé d'une pluralité d'éléments conducteurs connectés en parallèle, peut constituer le primaire d'un transformateur, l'autre bobinage formé d'une pluralité d'éléments conducteurs en série, constituant le secondaire du transformateur. Dans cette configuration, les éléments conducteurs ou branches conductrices du bobinage « de courant », reçoivent respectivement un courant Iⱼ égal à une portion ou une subdivision du courant I à mesurer. Les signaux générés par chaque subdivision de courant se superposent dans les éléments conducteurs du bobinage de détection qui sont en série. Le signal de sortie du bobinage de détection est proportionnel en petits signaux au courant total à mesurer.

Selon une deuxième possibilité de configuration du dispositif de mesure de courant, adaptée à une mesure de courants faibles par exemple comprise entre 100 nA et 100 mA, le premier bobinage, formé d'une pluralité d'éléments conducteurs en parallèle peut jouer le rôle « de contre réaction », le deuxième bobinage formé d'une pluralité d'éléments conducteurs en parallèle, jouant le rôle du bobinage « de courant ». Avec un même capteur, on peut ainsi mesurer une large gamme de courants par exemple comprise entre 100 nA et 10 A avec une très bonne résolution.

Des moyens de commutation peuvent être prévus pour placer le dispositif de mesure de courant dans la première configuration ou dans la deuxième configuration et pour faire passer de la première configuration à la deuxième configuration ou inversement. Les moyens de commutation peuvent comprendre des relais statiques, des interrupteurs électromécaniques ou MEMS (MEMS pour microsystèmes électromécaniques).

Le capteur de courant suivant l'invention s'applique au domaine des micro-technologies et peut être réalisé sous forme miniaturisée, par exemple à l'aide de techniques de fabrication en couches minces et/ou utilisées en microélectronique. Dans ce cas le capteur de courant sera appelé micro-capteur.

Un exemple de microcapteur de courant suivant l'invention, dans la première configuration dite « de mesure de courants élevés », va à présent être donné en liaison avec les figures 2A à 2E (représentant le capteur selon des vues de dessus) et 3A à 3D (représentant le capteur selon des vues en coupe transversale).

Dans cet exemple, le microcapteur est doté d'un circuit magnétique, et de 4 bobinages 110, 120, 140, 160, indépendants réalisés sur un même support, qui peut être un substrat 100, par exemple semiconducteur, recouvert d'un empilement 101 de couches minces. Le circuit magnétique est formé d'un premier noyau 102 magnétique ayant une direction principale donnée et d'un deuxième noyau 104 magnétique de direction principale parallèle à celle du premier noyau 102 (la direction principale du premier noyau 102 et du deuxième noyau 104 étant définies par une direction parallèle au vecteur *̅i̅*̅ d'un repère orthogonal [O; *i̅; j̅; k̅*])*.* Le premier noyau 102 et le deuxième noyau 104 sont situés dans un même plan parallèle au plan principal du substrat (le plan principal du substrat étant défini comme un plan, passant par le substrat et parallèle au plan [O; *̅i̅*̅ ; *̅j̅*̅]). Le premier noyau 102 magnétique et le deuxième noyau 104 magnétique peuvent être par exemple sous forme de blocs parallélépipédiques à base d'un matériau magnétique, par exemple du FeNi, reposant sur une couche de matériau diélectrique, par exemple du SiO₂. Les noyaux 102 et 104 ont une longueur respective (mesurée dans une direction parallèle au vecteur *̅i̅*̅)̅, qui peut être par exemple comprise entre 100 µm et 10000 µm ou de l'ordre de 1000 µm. La largeur respective des noyaux 102 et 104 (mesurée dans une direction parallèle au vecteur *̅j̅*̅) peut être comprise par exemple entre 10 µm et 1000 µm, ou de l'ordre de 100 µm. Les noyaux 102 et 104 ont une épaisseur respective (mesurée dans une direction parallèle au vecteur *̅k̅*̅) qui peut être par exemple comprise entre 0,1 µm et 50 µm, ou entre 1 µm et 5 µm. Selon une possibilité de mise en oeuvre, les noyaux 102, 104 peuvent être distincts ou disjoints ou ne pas être reliés entre eux. Pour réduire le gradient de champ extérieur entre les deux noyaux et conférer une meilleure insensibilité aux champs perturbateurs, les deux noyaux 102 et 104 peuvent être séparés au plus de plusieurs dizaines de micromètres. Selon une variante (non représentée), le circuit magnétique du capteur peut être fermé, les noyaux 102 et 104 étant reliés entre eux. La distance minimale entre les bobinages 110, 120, 140, 160, et les noyaux 102, 104 peut être de l'ordre de 1 micromètre ou inférieure à 1 micromètre.

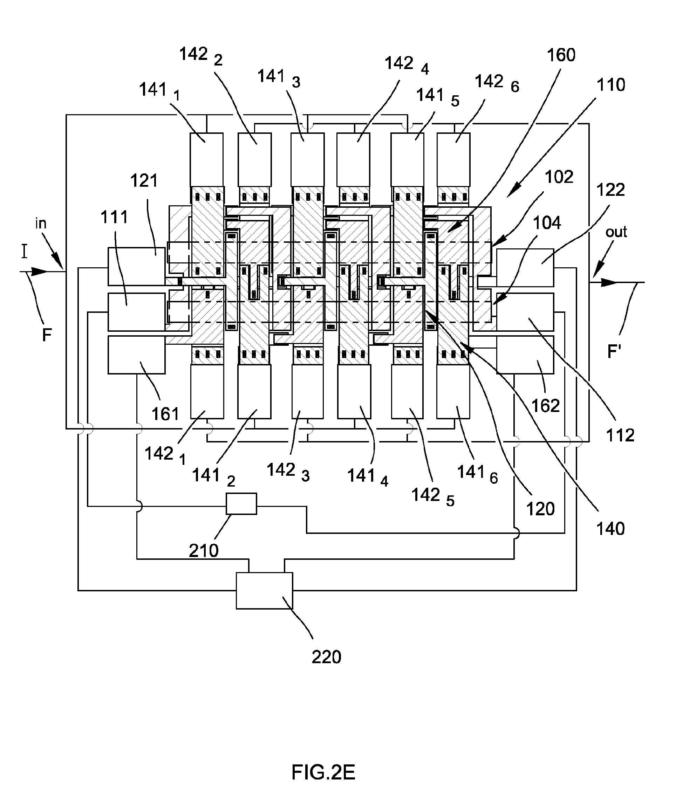

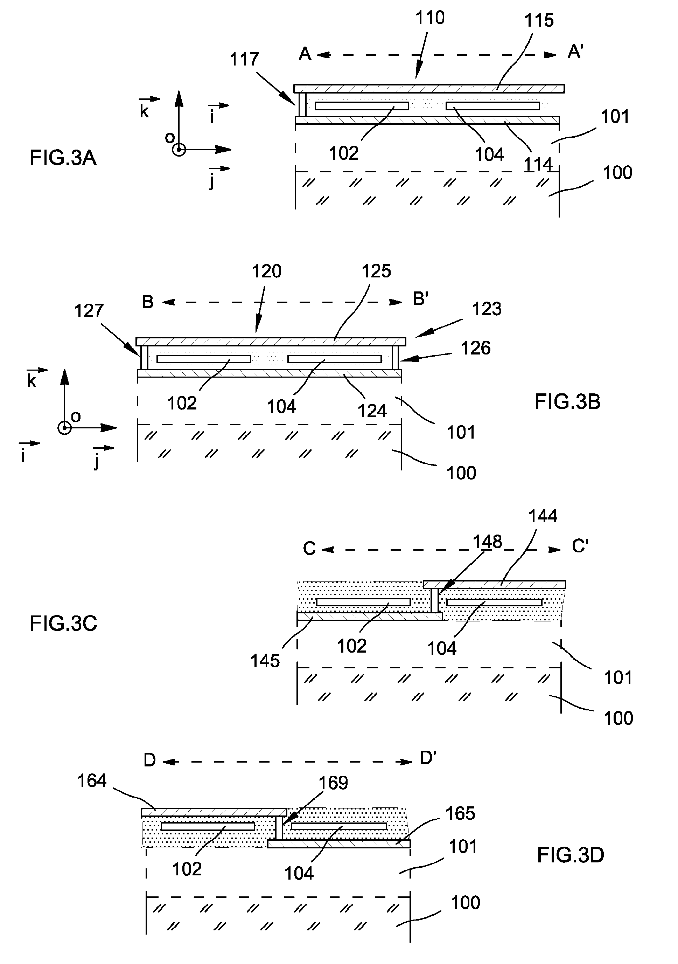

Le microcapteur de courant est doté tout d'abord d'un bobinage d'excitation 110 (figures 2A et 3A, les autres bobinages 120, 140, 160 n'étant pas représentés sur ces figures). Le bobinage d'excitation 110 est connecté à un circuit d'excitation 210 (représenté sur la figure 2E) par l'intermédiaire de plots de connexion 111, 112. Le circuit d'excitation 210 peut être prévu pour délivrer un signal d'excitation sous forme d'un signal sinusoïdal ou d'un signal carré ou d'un signal triangulaire ou avantageusement d'une succession d'impulsions de courant, par exemple alternativement positives et négatives. Le bobinage de d'excitation 110 est prévu pour, lorsqu'il reçoit un signal d'excitation provenant du circuit d'excitation 210, produire un champ magnétique d'excitation et saturer les noyaux 102, 104. Le bobinage d'excitation 110 peut être formé d'une succession d'éléments conducteurs, agencés en série le long des noyaux 102 et 104. L'agencement du bobinage d'excitation 110 est prévu de sorte qu'une composante de champ d'excitation est destinée à être produite au niveau du premier noyau 102, et qu'une composante du champ d'excitation sensiblement de même intensité et de même sens est destinée à être produite au niveau du deuxième noyau 104. Le bobinage d'excitation 110 comporte des zones conductrices plates 114 situées en regard du premier noyau 102 et du deuxième noyau 104 et reposant dans un premier plan situé entre le substrat 100 et les noyaux 102, 104. Le bobinage d'excitation 110 comporte également des zones conductrices plates 115 situées en regard du premier noyau 102 et du deuxième noyau 104 et reposant dans un deuxième plan, le deuxième plan étant tel que les noyaux 102, 104 sont placés entre le premier plan et le deuxième plan (figure 3A représentant une vue en coupe transversale A'A indiquée sur la figure 2A). L'agencement du bobinage 110 peut être tel que les zones conductrices plates 114 reposant dans le premier plan sont connectées respectivement à au moins une zone conductrice plate 115 reposant dans le deuxième plan, par l'intermédiaire d'au moins une interconnexion verticale ou d'un via métallisé 117. Le bobinage d'excitation 110 peut être également tel qu'hormis les zones conductrices plates reliées aux plots de connexion 111, 112, les zones conductrices plates 114 reposant dans le premier plan sont chacune connectées et superposées à une zone conductrice plate 115 reposant dans le deuxième plan. Cet agencement peut permettre d'obtenir une rapide saturation des noyaux 102, 104 par passage, en regard des noyaux 102, 104, de nappes de courant ayant des directions parallèles et des sens opposés.

Le microcapteur de courant est également doté d'un bobinage de détection 120 (figures 2B et 3B, les autres bobinages 110, 140, 160 n'étant pas représentés sur ces figures) connecté à un circuit électronique 220 de détection et de contre-réaction (représenté sur la figure 2E) par l'intermédiaire de plots de connexion 121, 122. Le circuit électronique 220 de détection peut comprendre des moyens formant un amplificateur et des moyens formant un intégrateur. Le bobinage de détection est agencé de manière à ce qu'une détection ou une mesure différentielle entre les champs produits au niveau du premier noyau 102, et les champs produits au niveau du deuxième noyau 104, puisse être effectuée. Le bobinage de détection 120 est formé d'une succession de contours conducteurs 123 ou de bagues conductrices 123 entourant les noyaux 102, 104 et relié(e)s entre eux ou entre elles, en série le long des noyaux 102 et 104. Les contours conducteurs 123 peuvent être constitués chacun de deux demi-contours de dimensions égales, un premier demi-contour conducteur entourant le premier noyau 102 et un deuxième demi-contour conducteur entourant le deuxième noyau 104. Un contour conducteur 123 (représenté sur la figure 3B selon une vue en coupe transversale B'B indiquée sur la figure 2B) du bobinage de détection 120 peut être formé d'une première zone conductrice plate 124 située dans le premier plan et en regard des noyaux 102, 104, d'une deuxième zone conductrice plate 125 située dans le deuxième plan et en regard des noyaux 102, 104, d'une première interconnexion verticale 126 reliant la première zone conductrice plate 124 à la deuxième conductrice plate 125, ainsi que d'une deuxième interconnexion verticale 127 reliant la première zone conductrice plate 124 à la deuxième conductrice plate 125. Les noyaux 102 et 104 sont situés entre la première interconnexion 126 et la deuxième interconnexion 127 d'une part, et entre la première zone conductrice plate 124 et la deuxième zone conductrice plate 125 d'autre part. Les contours conducteurs 123 du bobinage de détection 120 peuvent être connectés entre eux par l'intermédiaire d'un premier lien 128 parallèle à la direction principale des noyaux situé entre les noyaux 102, 104, dans le premier plan et d'un deuxième lien 129, parallèle à la direction principale des noyaux, et situé entre les noyaux 102, 104, et dans le deuxième plan. Le premier lien 128 et le deuxième lien 129 peuvent être reliés entre eux par l'intermédiaire d'une interconnexion verticale ou via 130 situé(e) entre les noyaux 102, 104. Le bobinage de détection 120 est agencé de sorte qu'un courant arrivant à un desdits contours conducteurs se réparti en deux composantes de courant entre les deux demi-contours formant le contour conducteur 123. Un courant traversant le bobinage de détection 120 se réparti de manière synchrone entre lesdits deux demi-contours autour du premier noyau 102 et du deuxième noyau 104.

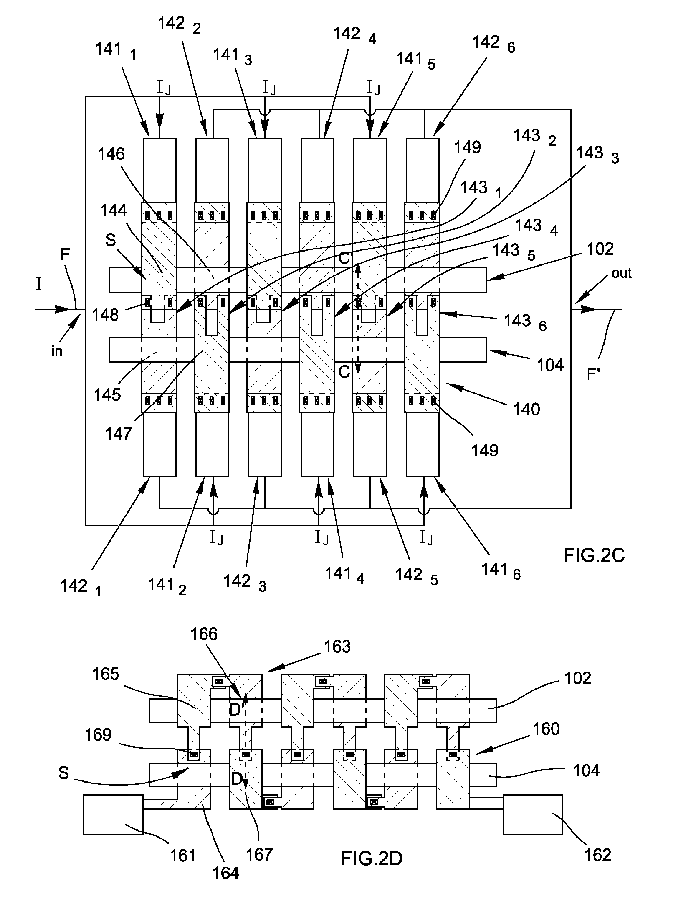

Le microcapteur de courant comprend également un bobinage 140 (figures 2C et 3C, les autres bobinages 110, 120, 160 n'étant pas représentés) formé d'une pluralité d'éléments conducteurs ou de branches conductrices 143₁,..., 143₆ reliées ou connectées entre elles en parallèle, et disposées le long des noyaux 102 et 104. Les branches conductrices 143₁,..., 143₆ peuvent être formées respectivement d'une zone conductrice plate passant en regard du premier noyau 104 et située dans l'un desdits premier plan ou deuxième plan, la zone conductrice plate étant reliée, par exemple par l'intermédiaire d'un ou plusieurs vias 148 à une autre zone conductrice plate passant en regard du deuxième noyau 104 et située dans l'autre desdits deuxième plan ou premier plan (figure 3C représentant une vue en coupe transversale C'C indiquée sur la figure 2C du bobinage 140). Le bobinage 140 peut être formé le long des noyaux 102, 104, d'une succession de branches conductrices 143₁,..., 143₆, comportant alternativement une branche conductrice formée d'une première zone conductrice plate 144 passant en regard du premier noyau 104 et située dans le deuxième plan reliée à une autre zone conductrice plate 145 passant en regard du deuxième noyau 104 et située dans le premier plan, et une branche conductrice formée d'une troisième zone conductrice plate 146 passant en regard du premier noyau 102 située dans le premier plan et reliée à une quatrième zone conductrice plate 147 passant en regard du deuxième noyau 104 et située dans le deuxième plan. De par l'agencement des zones conductrices plates, les branches conductrices 143₁,..., 143₆ sont prévues respectivement pour créer un premier champ magnétique élémentaire au niveau du premier noyau et au niveau du deuxième noyau, un deuxième champ magnétique élémentaire sensiblement égal au premier champ magnétique élémentaire, mais de direction opposée. Les branches conductrices 143₁,..., 143₆ peuvent être reliées respectivement à un plot d'entrée et à un plot de sortie par l'intermédiaire d'un ou plusieurs vias 149.

Dans la configuration de mesure de courants élevés, le bobinage 140 joue le rôle du bobinage « de courant », et est relié par l'intermédiaire d'une pluralité de plots conducteurs 141₁,..., 141₆ d'entrée « in » à une zone conductice F, qui peut être un fil, ou une ligne, ou une piste conductrice ou un connecteur par lequel un courant I à mesurer est destiné à être amené. Les plots conducteurs 141₁,..., 141₆ d'entrée sont reliés électriquement ou connectés entre eux. Le courant I à mesurer est destiné à être divisé entre les branches conductrices 143₁,..., 143₆ du bobinage 140 de courant. On crée une nappe parallèle de subdivisions du courant à mesurer qui traverse le capteur de part en part. Les branches conductrices 143₁,..., 143₆ sont destinées à recevoir respectivement une fraction Ij du courant I que l'on souhaite mesurer. Une pluralité de plots conducteurs 142₁,... ,142₆, de sortie « out », reliés électriquement entre eux sont également prévus. Dans la configuration de mesure de courants élevés, le bobinage 140 est susceptible de former le primaire d'un transformateur.

Le capteur comprend également un bobinage 160 (figures 2D et 3D, les autres bobinages 110, 120, 140, n'étant pas représentés sur ces figures). Le bobinage 160 comprend une pluralité d'éléments conducteurs 163 reliés ou connectés entre eux en série et disposés le long des noyaux 102 et 104. Les éléments conducteurs 163 peuvent être formées respectivement d'une première zone conductrice plate 164, reliée en série à une deuxième zone conductrice plate 165, reliée en série à une troisième zone conductrice plate 166, reliée en série à une quatrième zone conductrice plate 167. La première zone conductrice plate 164 passe en regard du deuxième noyau 104 et est située dans le premier plan. La deuxième zone conductrice plate 165 passe en regard du premier noyau 102 et est située dans le deuxième plan. La troisième zone conductrice plate 166 passe en regard du premier noyau 102 et est située dans le premier plan. La quatrième zone conductrice plate 167 passe en regard du deuxième noyau 104 et est située dans le deuxième plan. Des vias 169 peuvent permettre de relier un élément conducteur à un élément conducteur suivant du bobinage 160, et une zone conductrices plate 164, 165, 166, 167 d'un élément conducteur à une autre zone conductrice plate du bobinage 160 (figure 3D représentant une vue en coupe transversale D'D indiquée sur la figure 2D du bobinage primaire). Dans la configuration dite « de mesure de courants élevés » le bobinage 160 joue le rôle de bobinage de contre réaction. Le bobinage 160 est relié par l'intermédiaire de plots conducteurs 161 et 162 au circuit 220 de contre réaction (illustré sur la figure 2E). Un courant de contre réaction issu de ce circuit 220 est réinjecté dans le bobinage 160. De par l'agencement des zones conductrices plates, les éléments conducteurs 163 sont prévus respectivement pour créer une première composante de champ magnétique de contre réaction au niveau du premier noyau 102 et au niveau du deuxième noyau 104, une deuxième composante de champ magnétique de contre réaction sensiblement égale à la première composante de champ magnétique de contre réaction, mais de sens opposé à celui de la première composante.

Le bobinage 160 et le bobinage 140 sont disposés de préférence de sorte que, les zones 164, 165, 166, 167, du bobinage 160, situées en regard des noyaux 102, 104, sont superposées respectivement avec les zones conductrices plates 145, 144, 146, 147, du bobinage 140 situées en regard des noyaux 102, 104. Dans une région située en regard des noyaux 102, 104, les zones 164, 165, 166, 167, du bobinage 160, et les zones conductrices plates 145, 144, 146, 147, du bobinage 140 peuvent avoir des surfaces S (mesurée dans le plan [O; *̅i̅*̅;*̅j̅*̅ ]); égales. Le courant de contre-réaction peut ainsi compenser exactement le champ local produit par chaque subdivision du courant à mesurer. Dans la configuration précédemment décrite, la puissance dissipée pour un courant de 10A, peut être par exemple de l'ordre de 50 mW au niveau du bobinage 140 de courant et par exemple de l'ordre de 22 mW au niveau du bobinage 160 de contre réaction, la puissance totale dissipée étant de l'ordre de 72 mW. La puissance dissipée par le capteur est inférieure à celle d'un shunt qui, par exemple, pour un courant à mesurer de 10A et une chute de tension de 100 mV dissipe une puissance de l'ordre de 1W.

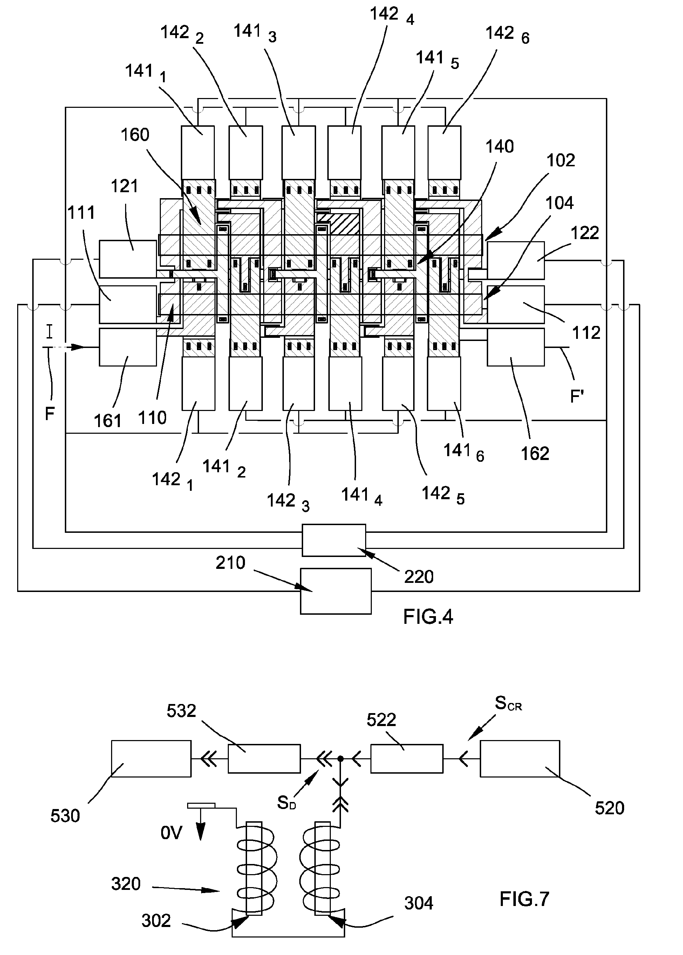

Dans le cas où de faibles courants sont à mesurer, les bobinages de « courant » et de « contre-réaction » peuvent être inversés. Sur la figure 4, le microcapteur de courant suivant l'invention, se trouve dans une deuxième configuration dite « de mesure de courants faibles ». Le bobinage 160 formé d'éléments conducteurs reliés en série, joue le rôle du bobinage de « courant » par lequel passe le courant I à mesurer. Le bobinage 140 formé d'éléments conducteurs reliés en parallèle, joue cette fois le rôle de bobinage de contre réaction et est connecté au circuit de contre réaction 220. Des moyens de commutation peuvent être prévus pour passer de la première configuration à la deuxième configuration et inversement. Un FPGA (FPGA pour field programmable gate array ou réseau prédiffusé programmable) ou un ASIC (ASIC pour circuit intégré à application spécifique) ou des composants électroniques discrets peuvent permettre de gérer la stratégie de commutation, jouer un rôle de protection des calibres, mettre en oeuvre une contre réaction à champ nul et éventuellement commander un dispositif d'affichage de résultats de mesure.

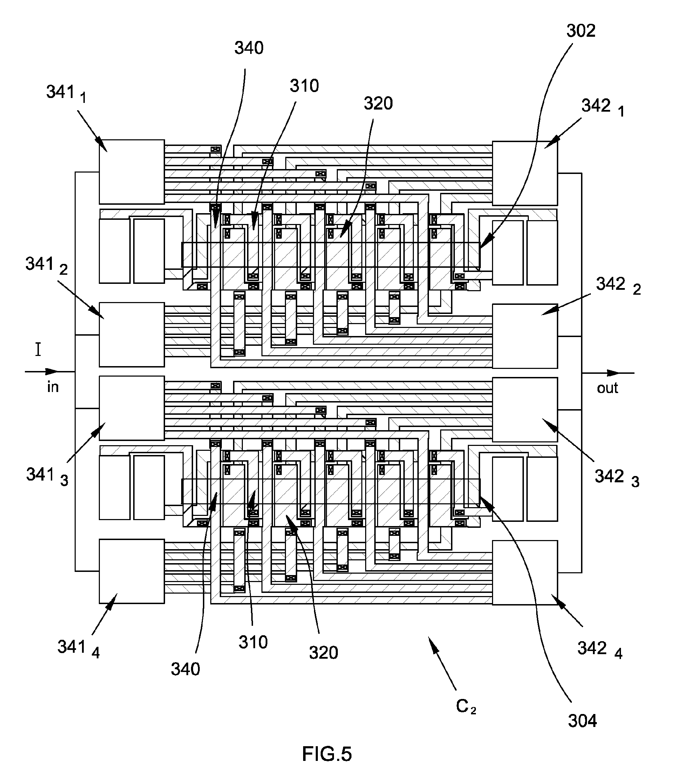

Sur la figure 5, une variante de mise en oeuvre du capteur suivant l'invention est illustrée. Le capteur comporte un circuit magnétique formé de 2 noyaux magnétiques 302, 304, sous forme de 2 branches parallèles et disjointes. Pour cette variante, un bobinage 320 joue à la fois le rôle bobinage de détection et de contre réaction. Le bobinage de détection 320 peut être formé d'une pluralité d'éléments conducteurs reliés en série passant en regard du premier noyau 302 et d'une autre pluralité d'éléments conducteurs reliés en série passant en regard du deuxième noyau 304. Le capteur comprend également un bobinage d'excitation 310 formé d'une pluralité d'éléments conducteurs reliés en série passant en regard du premier noyau 302 et d'une autre pluralité d'éléments conducteurs reliés en série passant en regard du deuxième noyau 304. Un courant I à mesurer est subdivisé à parts égales dans des plots 341₁, 341₂, 341₃, 341₄, passe dans un bobinage 340 « de courant », puis ressort par des plots 342₁, 342₂, 342₃, 342₄. Le bobinage 340 de courant comporte une pluralité d'éléments conducteurs connectés en parallèle, passant au dessus du premier noyau 304 et reliant un premier plot conducteur d'entrée 341₁ du courant I et un premier plot conducteur de sortie 342₁. Une pluralité d'éléments conducteurs connectés en parallèle, passent au dessous du premier noyau 304 et relient un deuxième plot conducteur d'entrée 341₂ du courant I et un deuxième plot conducteur de sortie 342₂. Le bobinage 340 de courant comporte également une pluralité d'éléments conducteurs connectés en parallèle, passant au dessus du deuxième noyau 304 et reliant un troisième plot conducteur d'entrée 341₃ du courant I et un troisième plot conducteur de sortie 342₃, ainsi qu'une pluralité d'éléments conducteurs connectés en parallèle, passant au dessous du deuxième noyau 304 et connectés à un quatrième plot conducteur d'entrée 341₄ du courant I et à un quatrième plot conducteur de sortie 342₄.

Par rapport au mode de réalisation avec détection et contre réaction séparées, ce mode de réalisation peut être utilisé notamment lorsque l'on privilégie une miniaturisation du dispositif par rapport à une précision de la mesure.

La figure 7 représente le bobinage de détection 320 (les autres bobinages du capteur n'étant pas représentés sur cette figure) connecté avec un circuit de détection 530 susceptible de recevoir un signal de détection S_{D} en provenance du bobinage de détection et avec un circuit de contre réaction susceptible d'émettre un signal de détection S_{CR} 530 à destination du bobinage de détection. Un filtre passe haut 532 peut être prévu entre la sortie du bobinage de détection 320 et le circuit de détection 530, tandis qu'un filtre passe bas 522 peut être prévu entre la sortie du bobinage de détection 320 et le circuit de contre réaction 520. En entrée du bobinage de détection, un potentiel constant par exemple de 0 volt peut être appliqué.

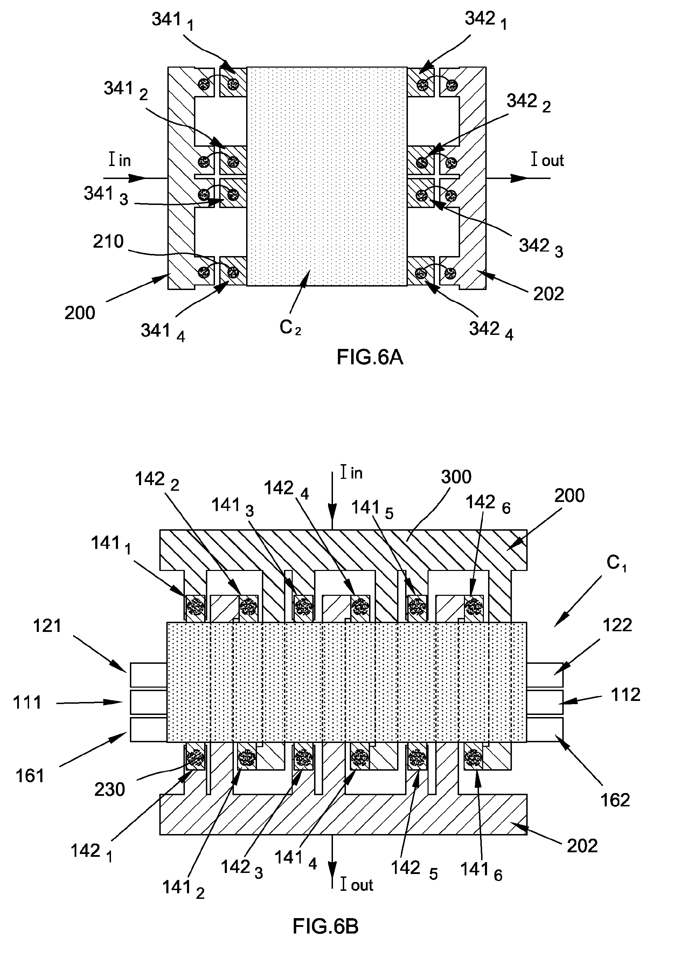

La figure 6A illustre un exemple d'assemblage d'un micro-capteur C2 tel que celui précédemment décrit en liaison avec la figure 5, avec des connecteurs 200, 202, d'un circuit imprimé rigide ou souple aptes à laisser passer de forts courants. Le capteur est destiné à être placé en série sur une ligne conductrice ou une zone conductrice qu'un courant I traverse et que l'on souhaite mesurer. La zone conductrice peut être assemblée par l'intermédiaire des connecteurs 200, 202 par soudure ou brasure. Le microcapteur est également connecté à un ou plusieurs circuit(s) électronique(s) ou un ASIC (ASIC pour circuit intégré à application spécifique) prévus pour réaliser les fonctions d'excitation et de détection.

Sur la figure 6A, les plots 341₁,..., 341₄ d'entrée et les plots de sortie 342₁,..., 342₆ d' entrée du bobinage primaire 340 sont respectivement reliés aux connecteurs 200, 202, par l'intermédiaire de fils de microcâblage 210 (« wire-bonding » selon la terminologie anglo-saxonne), par exemple des fils d'or. Les plots des autres bobinages 310, 320, (non représentés sur la figure 6A) sont connectés vers le ou les circuit(s) électronique(s) ou vers l'ASIC. La figure 6B illustre un exemple d'assemblage d'un micro-capteur C1 tel que celui décrit en liaison avec la figure 2E, avec des connecteurs 200, 202, d'un circuit imprimé rigide ou souple aptes à laisser passer de forts courants. Le capteur C1 est destiné à être placé en série sur une ligne conductrice ou une zone conductrice qu'un courant I traverse et que l'on souhaite mesurer. La zone conductrice peut être assemblée par l'intermédiaire des connecteurs 200, 202 par soudure ou brasure. Le microcapteur est également connecté à un ou plusieurs circuit(s) électronique(s) ou un ASIC (ASIC pour circuit intégré à application spécifique) prévus pour réaliser les fonctions d'excitation et de détection.

Sur la figure 6B, les plots 141₁,..., 141₆ d'entrée et les plots de sortie 142₁,..., 142₆ d'entrée du bobinage primaire 140 sont respectivement reliés aux connecteurs 200, 202 par l'intermédiaire de boules conductrices 230 d'alliage par exemple technique de puce retournée (« Flip-chip » selon la terminologie anglo-saxonne). Une symétrie au niveau des plots, connexions, lignes d'amenées de courant, soudures ou brasures du capteur, est de préférence respectée afin d'équilibrer au mieux la subdivision du courant à mesurer, d'homogénéiser au mieux le champ créé par le courant à mesurer, de compenser ce courant le plus exactement possible et donc d'estimer le courant à mesurer sans introduire ni décalage statique, ni dérive temporelle, ni erreur dynamique dans le signal de sortie.

## Revendications

1. Dispositif de mesure de courant doté d'au moins un capteur de courant comportant : un circuit magnétique (102-104), ainsi qu'une pluralité de bobinages en regard du circuit magnétique dont .
- au moins un bobinage d'excitation (110, 210) chargé de l'excitation du circuit magnétique,
- au moins un bobinage dit de « courant », qu'un courant I à mesurer est destiné à traverser et qui est susceptible de produire un champ magnétique donné,
- au moins un bobinage de détection (120,320),
- au moins un bobinage dit « de contre réaction », distinct du bobinage de détection et destiné à produire un champ magnétique de contre réaction s'opposant au champ magnétique donné,
parmi lesdits bobinages de contre réaction et de courant du capteur figurant au moins un premier bobinage (140,340) comportant une première pluralité de zones conductrices situées en regard du circuit magnétique et connectées entre elles en parallèle, couplé par couplage magnétique à au moins un deuxième bobinage (160,360) comportant une deuxième pluralité de zones conductrices situées en regard du circuit magnétique et connectées entre elles en série.

2. Dispositif de mesure de courant doté d'au moins un capteur de courant comportant un circuit magnétique (102-104), ainsi qu'une pluralité de bobinages en regard du circuit magnétique dont :
- au moins un bobinage d'excitation (110, 210) chargé de l'excitation du circuit magnétique,
- au moins un bobinage dit de « courant », qu'un courant I à mesurer est destiné à traverser et qui est susceptible de produire un champ magnétique donné,
- au moins un bobinage de détection (120,320), le bobinage de détection (320) jouant en outre le rôle d'un bobinage de contre réaction, destiné à produire un champ magnétique de contre réaction s'opposant au champ magnétique donné, parmi lesdits bobinages de contre réaction et de courant du capteur, figurant au moins un premier bobinage (140,340) comportant une première pluralité de zones conductrices situées en regard du circuit magnétique et connectées entre elles en parallèle, couplé par couplage magnétique à au moins un deuxième bobinage (160,360) comportant une deuxième pluralité de zones conductrices situées en regard du circuit magnétique et connectées entre elles en série.

3. Dispositif de mesure de courant selon la revendication 1 ou 2, dans lequel au moins plusieurs zones conductrices de la première pluralité de zones conductrices sont situées en regard respectivement d'une zone conductrice de même surface appartenant à la deuxième pluralité de zones conductrices.

4. Dispositif de mesure de courant selon l'une des revendications 1 à 3, susceptible d'adopter une configuration dite « de mesure de courants élevés » dans laquelle ledit premier bobinage (140,340) joue le rôle du bobinage de « bobinage de courant » et dans laquelle ledit deuxième bobinage (160,360) joue le rôle du bobinage « de contre réaction ».

5. Dispositif de mesure de courant selon l'une des revendications 1 à 4, susceptible d'adopter une configuration dite « de mesure de courants faibles » dans laquelle ledit premier bobinage (140,340) joue le rôle du bobinage « de contre réaction » et dans laquelle ledit deuxième bobinage (160,360) joue le rôle du « bobinage de courant ».

6. Dispositif de mesure de courant selon la revendication 5, comprenant en outre : des moyens de commutation aptes à faire commuter le dispositif entre la configuration de « mesure de courant faibles » et la configuration de « mesure de courants élevés ».

7. Dispositif de mesure de courant selon l'une des revendications 1 à 6, le circuit magnétique étant formé d'au moins un premier noyau magnétique (102) et d'au moins un deuxième noyau magnétique (104) parallèle au premier noyau.

8. Dispositif de mesure de courant selon la revendication 7, l'agencement du bobinage d'excitation (110) étant prévu de manière à produire, une première composante de champ d'excitation de sens donné au niveau du premier noyau, et une deuxième composante de champ d'excitation de même sens que le sens donné au niveau du deuxième noyau.

9. Dispositif de mesure de courant selon l'une des revendications 1 à 8, dans lequel le bobinage d'excitation comprend une pluralité de zones conductrices situées en regard du circuit magnétique et reliées entre elles en série.

10. Dispositif de mesure de courant selon la revendication 9, dans lequel l'agencement du bobinage de détection est prévu pour effectuer une mesure différentielle entre un champ magnétique au niveau du premier noyau et un champ magnétique au niveau du deuxième noyau.

11. Dispositif de mesure de courant selon l'une des revendications 1 à 10, dans lequel le bobinage de détection est formé d'une pluralité de bagues conductrices connectées entre elles, le circuit magnétique étant situé à l'intérieur d'au moins plusieurs desdites bagues.

12. Dispositif de mesure de courant selon l'une des revendications 1 à 11, comprenant en outre un circuit électronique (220,520) de contre réaction connecté au bobinage de détection et apte à délivrer un courant de contre réaction au bobinage de contre réaction.

13. Dispositif de mesure de courant selon l'une des revendications 1 à 12, comprenant en outre : un circuit d'excitation apte à délivrer un signal d'excitation en entrée du bobinage d'excitation.

14. Dispositif de mesure de courant selon la revendication 13, le circuit d'excitation comprenant des moyens générateurs d'impulsions aptes à émettre le signal d'excitation en entrée du bobinage d'excitation sous forme d'une succession d'impulsions de courant.

15. Dispositif microélectronique comprenant un dispositif selon l'une des revendications 1 à 14.
